# EUROPÄISCHE PATENTSCHRIFT

(11) **EP 3 191 665 B1**
(45) Veröffentlichungstag und Bekanntmachung des Hinweises auf die Patenterteilung: **23.10.2019**
(21) Anmeldenummer: 15753922.2
(22) Anmeldetag: 10.08.2015
(51) Int. Cl.: E05B 85/10, H03K 17/955, H03K 17/96

(54) **TÜRGRIFFANORDNUNG FÜR EIN KRAFTFAHRZEUG**
DOOR HANDLE ASSEMBLY FOR A MOTOR VEHICLE
SYSTÈME DE POIGNÉE DE PORTE D'UN VÉHICULE AUTOMOBILE

(30) Priorität: 08.09.2014 DE 102014112884; 07.01.2015 DE 102015100074
(43) Veröffentlichungstag der Anmeldung: 19.07.2017
(73) Patentinhaber: Huf Hülsbeck & Fürst GmbH & Co. KG, 42551 Velbert (DE)
(72) Erfinder: WITTE, Martin, 48683 Ahaus (DE); BECK, Andreas, 44795 Bochum (DE)
(74) Vertreter: Zenz Patentanwälte Partnerschaft mbB
(86) Internationale Anmeldenummer: PCT/EP2015/068385
(87) Internationale Veröffentlichungsnummer: WO 2016/037782

(56) Entgegenhaltungen:
- EP-A2- 2 053 744
- WO-A1-2004/063504
- DE-A1-102004 045 152
- DE-A1-102012 107 189

## Beschreibung

Die Erfindung betrifft eine Türgriffanordnung für ein Kraftfahrzeug. Insbesondere betrifft die Erfindung eine Türaußengriffanordnung zur Betätigung eines elektrischen Türschlosses.

Elektrisch angesteuerte Türschlösser sind im Stand der Technik bekannt. Diese werden häufig unter der allgemeinen Bezeichnung "e-latch" geführt. Ein derartiges Türschloss ist z.B. in der EP 0 584 499 A1 offenbart. Bei solchen Türgriffen wird keine durchgehende mechanische Wirkungskette vom Türgriff auf ein zugehöriges Türschloss eingerichtet. Stattdessen wird das Türschloss elektrisch angesteuert, so dass mechanische Hardware reduziert werden kann, was Kosten und Gewicht einspart.

Ein elektrisch angesteuertes Schloss ist dabei abzugrenzen von den bekannten Konzepten der fernbedienbaren Türentriegelung. Eine entriegelte Tür kann durch Betätigung des Türgriffes weiterhin mechanisch zu öffnen sein, um die Sperrfreigabe der mechanischen Komponenten des Türschlosses (insbesondere Drehfalle und Sperrklinke) aufzuheben. Bei einem elektrischen Türschloss geschieht diese Aufhebung der Sperre nach elektrischer Ansteuerung, die Drehfalle eines Türschlosses wird also unter elektrischer Ansteuerung und mit einer entsprechenden Servoeinheit oder Motoreinheit betätigt, ohne dass es einer Kraftausübung am Türgriff bedarf.

Bei derartigen elektrischen Türschlössern wird die mechanische Auslenkung oder Verstellung der Türgriffe überflüssig, sie können daher unbeweglich oder mit minimalem Bewegungsbereich (z.B. zur Betätigung eines Mikroschalters) am Fahrzeug befestigt werden.

Aus dem Dokument DE 10 2012 107 189 A1 ist ein Elektronikmodul für einen bewegbaren Türgriff bekannt, welcher mehrere Sensorelektroden für kapazitive Sensoren aufweist, welche in verschiedenen Kavitäten des Türgriffs vergossen sind.

Diese Anmeldung betrifft einen am Fahrzeug fixierten Türgriff, im Weiteren als feststehender Türgriff bezeichnet. Damit soll zum Ausdruck gebracht werden, dass der Türgriff mit seiner vom Benutzer betätigbaren Handhabe gegenüber der zugehörigen Tür nicht ausgelenkt oder verschwenkt wird, sondern lediglich als Griff dient, um eine elektrisch geöffnete Tür zu bewegen.

Es ist jederzeit zu gewährleisten, dass die Türgriffe einerseits möglichst wenig Aufwand bei der Herstellung und Wartung erfordern, und dass die Sicherheit eines derartigen Türgriffsystems jederzeit gewährleistet ist. Wird nämlich die Öffnung der Tür über ein elektrisches Türschloss nach Ansteuerung vorgenommen, ist sicherzustellen, dass der Öffnungswunsch eines Bedieners tatsächlich unzweifelhaft festgestellt wird. Die Belastung des Türgriffes, z. B. in einer Waschanlage, beim Polieren des Fahrzeuges, durch Fahrtwind oder Anlehnen darf niemals dazu führen, dass die Tür unerwünscht geöffnet wird.

Der Erfindung liegt die Aufgabe zugrunde, einen feststehenden Türgriff mit verlässlicher Funktionserkennung und gesteigerter Sicherheit auszubilden.

Diese Aufgabe wird erfindungsgemäß durch eine Türgriffeinrichtung mit den Merkmalen des Patentanspruches 1 gelöst. Außerdem wird die Aufgabe durch ein Verfahren mit den Merkmalen des Patentanspruches 8 gelöst.

Die erfindungsgemäße Türgriffeinrichtung ist mit einer mechanisch stabilen Handhabe/Griffteil ausgebildet, die mit wenigstens einem Befestigungsabschnitt am Fahrzeug festlegbar ist. Die Festlegung am Fahrzeug einer nach außen gerichteten Handhabe kann beispielsweise durch Befestigung am Türblech selbst, oder durch Durchgreifen des Türbleches und Arretierung von Befestigungsabschnitten an einem auf der Blechinnenseite liegenden Träger stattfinden. Unter mechanisch stabil ist dabei zu verstehen, dass die der Griff nicht zur Bewegung oder Auslenkung mit Hilfe von Gelenken, Lagern, Führungen, elastischen Mitteln oder ähnlichem vorgesehen ist. Eine Verformung im Elastizitätsbereich des Griffmaterials bei der Benutzung des Griffes ist jedoch vorgesehen.

Der erfindungsgemäße Türgriff weist eine Mehrzahl von Sensoren auf, wobei wenigstens einer dieser Sensoren ein kapazitiver Annäherungssensor ist.

Der kapazitive Annäherungssensor ist in dem Griff derart angeordnet, dass ein Hintergreifen des Griffes durch den kapazitiven Annäherungssensor detektiert wird. Die Anordnung derartiger kapazitiver Sensoren in Türgriffen ist bekannt, sie wird insbesondere bei sogenannten "Keyless-Entry-Sytemen" eingesetzt. Beispielhaft wird hier auf die Anmeldung DE 10 2005 055 515 A1 verwiesen.

Kapazitive Sensoren sind geeignet, die Annäherung eines Körperteils des Benutzers, insbesondere das Auflegen oder Annäherung einer Hand an den Türgriff zu detektieren. Der kapazitive Sensor ist erfindungsgemäß zur Innenseite der Handhabe des Türgriffes ausgerichtet, so dass ein Hintergreifen des Türgriffes überwacht wird. Erfindungsgemäß wird also der kapazitive Sensor in dem Türgriff verwendet, um die Anwesenheit der Hand eines Bedieners hinter der Handhabe, also ein Hintergreifen zu detektieren.

Weiterhin sind wenigstens zwei weitere Sensoren vorgesehen. Diese Sensoren sind in dem Griff so angeordnet, dass sie entlang des Umfangs des Griffs an unterschiedlichen Winkelpositionen, insbesondere an voneinander abgewandten Griffpositionen platziert sind. Die Anordnung dieser beiden Sensoren ist also derart, dass in einem Griffabschnitt beispielsweise einer der Sensoren zur Außenseite orientiert ist, während dem gleichen Griffabschnitt der andere Sensor zur Innenseite orientiert ist. In dem gleichen Griffabschnitt bedeutet, dass die Erfassungsbereiche des zweiten und des dritten Sensors in axialer Richtung des Griffes zu derselben Richtung gegenüber dem kapazitiven Sensor versetzt sind.

Wesentlich ist, dass der kapazitive Sensor bei der erfindungsgemäßen Türgriffanordnung ein Hintergreifen der Handhabe feststellen kann und die beiden anderen Sensoren in einem Griffabschnitt ein Umgreifen oder Umklammern erfassen. Beispielsweise können die beiden weiteren Sensoren in dem Bereich angeordnet werden, in dem bei einer üblichen Betätigung eines Türgriffes Zeigefinger und Daumen eines Bedieners zu liegen kommen. Während der erste Sensor als kapazitiver Sensor zur Überwachung des Hintergreifens der Handhabe ausgebildet ist, können die weiteren Sensoren sowohl kapazitive Sensoren als auch Sensoren anderer Art sein, beispielsweise Induktivität-DigitalUmsetzer (LDCs). Die Art der Detektion ist für die Erfindung zunächst nicht wesentlich. Beispielsweise können die voneinander abgewandt angeordneten Sensoren beide als kapazitive Sensoren wirken, so dass ein Umgreifen in diesem Abschnitt detektiert wird. Wird also der Türgriff sowohl hintergriffen als auch im entsprechenden überwachten Abschnitt umgriffen, so wird von einem Betätigungswillen ausgegangen und das elektronische Türschloss wird betätigt. In einer Weiterbildung der Erfindung ist es jedoch vorgesehen, dass einer der weiteren Sensoren als kraftempfindlicher Sensor ausgebildet ist. Obwohl der Türgriff als feststehender Türgriff ausgebildet ist, kann er grundsätzlich abschnittsweise mechanisch verformbar ausgebildet sein oder verformbare Abdeckungen aufweisen. Dafür können gezielt elastisch verformbare Abdeckungsteile oder Bereiche ausgebildet sein, es kann jedoch auch das Material des Griffkorpus selbst geringfügige, elastische Verformung zulassen.

Ein solcher kraftabhängiger Sensor kann beispielsweise mit einem Piezo realisiert werden, dessen Piezo-Spannung überwacht wird.

Die erfindungsgemäße Anordnung von mehreren Sensoren im Türgriff, welche sowohl ein Hintergreifen als auch ein zumindest teilweises Umgreifen des Türgriffes überwachen, erhöht die Sicherheit des Türgriffes wesentlich. Bei feststehenden Türgriffen, welche z.B. eine Verformung des Griffes überwachen, besteht die Gefahr, dass Verformungen beispielsweise im Fahrbetrieb oder bei der Reinigung des Fahrzeuges oder aber Torsionsverformungen beim Abstellen des Fahrzeugs auf unebenem Untergrund (Parken mit zwei Rädern auf einem erhöhten Gehweg) als Betätigungen des Griffes erkannt werden.

Naturgemäß muss die Erkennung auf Verformung eines feststehenden Türgriffes außerdem sehr sensitiv sein, da ansonsten bei Betätigung der Benutzer zu hohe Kräfte abverlangt werden. Dies führt jedoch dazu, dass die Systeme gemäß dem Stand der Technik auch sensitiv hinsichtlich Fehlbetätigungen sind. Die erfindungsgemäße Anordnung mit kapazitivem Überwachen des Hintergreifens und zusätzlicher Umgreifungsüberwachung schützt gegen derartige Fehlbetätigungen zuverlässig.

Nur wenn die Signale der Sensoren anzeigen, dass ein klarer Bedienwunsch vorliegt, wird die elektrische Öffnung vorgenommen.

Die im Griff verbauten Sensoren können für weitere Betätigungsaufgaben überwacht werden. Beispielsweise kann eine Verriegelung des Schlosses nach Schließen der Tür veranlasst werden, wenn der Benutzer seine Hand im überwachten Bereich an die Außenseite des Türgriffes anlegt und dort für eine vorgegebene Zeitdauer belässt.

In einer bevorzugten Ausführungsform der Erfindung ist die Türgriffanordnung derart geschaltet, dass zunächst die Sensoren für die Überwachung eines Umgreifens eines Griffabschnittes deaktiviert sind, während der kapazitive Sensor zur Überwachung des Hintergreifens aktiv ist. Sobald ein Hintergreifen detektiert wird, werden die anderen Sensoren geweckt und überwacht. In dieser Gestaltung ist der Energiebedarf des Türgriffes optimiert, wobei die Sicherheit und der Komfort voll erhalten bleiben.

In einer besonders bevorzugten Ausführungsform ist bei den weiteren Sensoren derjenige Sensor, der zur Innenseite der Handhabe gerichtet ist als Kraftsensor Sensor ausgebildet, während der zur Außenseite hin ausgerichtete Sensor als kapazitiver Sensor ausgebildet ist. Wie bereits oben beschrieben, kann ein kraftempfindlicher Sensor beispielsweise mit einem Piezosensor ausgebildet sein oder mit einem LDC-Sensor oder auch mit einem Hall-Sensor, wobei diese Sensoren dann derart in der Innenseite des Griffes befestigt sind, dass ein auf den entsprechenden Türgriffbereich ausgeübter Druck beim Umgreifen eine Verformung des Gehäuses in diesem Abschnitt bewirkt, was zu einem Sensorsignal führt.

Die Ausbildung eines nach innen gerichteten Sensors als Drucksensor oder Kraftsensor verringert die Fehlbetätigungen weiter. Beim Durchfahren einer Waschanlage gibt es beispielsweise Situationen, in denen Teile der Waschbürsten den Türgriffen von beiden Seiten umgeben, was fälschlich als ein Umgreifen erkannt werden könnte. Wird jedoch eine Druckausübung auf die Innenseite des Türgriffes, beispielsweise durch Zug am Türgriff aufgebaut, so wird eine solche Druckkraft regelmäßig nicht bei derartigen Waschvorgängen aufgebaut und eine Fehlbetätigung vermieden.

Des Weiteren hat eine solche Gestaltung den wesentlichen Vorteil, dass durch ein erzwungenermaßen festes Umgreifen des Türgriffes eine unangenehme Berührung oder sogar Verletzung durch Aufschlagen der Tür an den Handrücken verhindert wird. Es ist daran zu erinnern, dass bei einem elektrisch betätigten Türschloss die Öffnung der Tür an sich elektrisch aktiviert und vorgenommen wird und sich die Tür entsprechend durch einen elektrischen Antrieb aus ihrer Schließposition in Richtung der Öffnungsstellung wenigstens einige Zentimeter aktiv beschleunigt wird. Ein Benutzer, der seine Hand in diesem Bereich führt, um die Öffnung zu veranlassen, könnte mit der Hand der Türgriffhandhabe von dieser aktiven Beschleunigung der Tür überrascht werden und ggf. einen Schlag auf die eingeführte Hand erhalten. Ist jedoch das feste Umgreifen und die Druckbetätigung auf der Innenseite des Türgriffes zwingend erforderlich, um eine Öffnung der Tür zu veranlassen, kann sichergestellt werden, dass der Benutzer vor einem solchen Schlag geschützt wird, da die ausgeübte Kraft des Benutzers in dieselbe Richtung geht wie die Öffnung.

In einer Weiterbildung der Erfindung ist vorgesehen, dass entlang der Handhabe weitere Sensoren ausgebildet sind. Diese Sensoren überwachen eine Kraftausübung in weiteren Bereichen entlang der Handhabe. Beispielsweise sind dafür mehrere LDC-Sensoren entlang der Innenseite der Handhabe verteilt und detektieren eine Verformung des Handhabengehäuses des Griffes. Derartige LDC-Sensoren sind auf einer Steuerelektronik im Griffinneren einfach auszubilden, indem eine Spule auf einer Schaltungsplatine ausgebildet wird und gegenüberliegend im Griff, beispielsweise anliegend auf der Innenseite des Griffgehäuses, ein metallisches Element platziert wird. Wird das Gehäuse verformt, bewegt sich das anliegende Metallstück gegenüber der Spulenanordnung und die Sensoren sprechen an. Dazu kann auch vorgesehen sein, dass die mechanische Verformbarkeit in diesem Bereich gezielt beeinflusst ist, beispielsweise durch die Ausbildung der Innenseite des feststehenden Türgriffes mit einem elastischen Material.

Vorzugsweise sind außerdem sämtliche Sensorkomponenten und die zugehörige Schaltung im Griffinnenteil mit einer elastischen Vergussmasse vergossen, so dass sie gegenüber Umwelteinflüssen geschützt sind und die elastische Vergussmasse gleichzeitig eine gewisse Federwirkung ausübt, beispielsweise für den Abstand der metallischen Elemente zu den Spulen der LDC-Sensoren.

Diese auf der Innenseite des Türgriffes angeordneten weiteren verformungs- oder kraftsensitiven Sensoren können ergänzend zu den Sensoren ausgebildet sein, die das Umgreifen des Griffes in einem vorgegebenen Griffabschnitt überwachen. Zusätzlich zu der kapazitiven Überwachung des Hintergreifens kann dann überwacht werden, ob bei Bedienwunsch in einem größeren Abschnitt des Griffes eine Zugbetätigung vorliegt. Es ist ebenfalls möglich, die Bedienung unterschiedlicher Griffabschnitte auch unterschiedlichen Betätigungsmustern zuzuordnen.

Das erfindungsgemäße Verfahren nutzt die Anordnung der verschiedenen Sensoren im Türgriff, um einen klaren Betätigungswillen festzustellen. Dazu weißt es die Schritte auf:
Erfassen eines Hintergreifens des Türgriffs in einem ersten Abschnitt durch Überwachen der Signale eines ersten kapazitiven Sensors der Sensoranordnung,
Erfassen einer Berührung des Türgriffs von der Außenseite in einem zweiten Abschnitt durch Überwachen der Signale eines zweiten Sensors der Sensoranordnung,
Erfassen einer Berührung des Türgriffs von der Innenseite in dem zweiten Abschnitt durch Überwachen der Signale eines dritten Sensors der Sensoranordnung,
Erzeugen von Steuersignalen mit der Ansteuerungs- und Auswerteelektronik, wobei ein Öffnungssignal dann generiert wird, wenn zeitgleich sowohl ein Hintergreifen des Türgriffs erfasst wird und der zweite und der dritte Sensor jeweils eine Berührung erfassen.

Es ist gemäß dem Verfahren wesentlich, dass die Sensorsignale in Kenntnis der Anordnung der Sensoren im Griff in Kombination ausgewertet werden. Die Zeitgleichheit der Sensorsignale muss gegeben sein, die Sensoren müssen also simultan eine Betätigung anzeigen. Die Signale werden dazu mit einer UND-Bedingung verknüpft um nur solche Fälle als Bedienung zu erkennen, die eine an der menschlichen Hand und Bedienpraxis orientiertes Betätigungsmuster wiedergeben.

Die Erfindung wird nun anhand der beiliegenden beispielhaften Figuren näher erläutert.
Figur 1a zeigt eine Handannäherung an einen feststehenden Türgriff;
Figur 1b zeigt ein Hintergreifen des feststehenden Türgriffes;
Figur 2 zeigt eine schematische Darstellung der Anordnung von Komponenten im feststehenden Türgriff gemäß einem ersten Ausführungsbeispiel;
Figur 3 zeigt die schematische Darstellung der Anordnung von Komponenten im feststehenden Türgriff gemäß einem zweiten Ausführungsbeispiel.

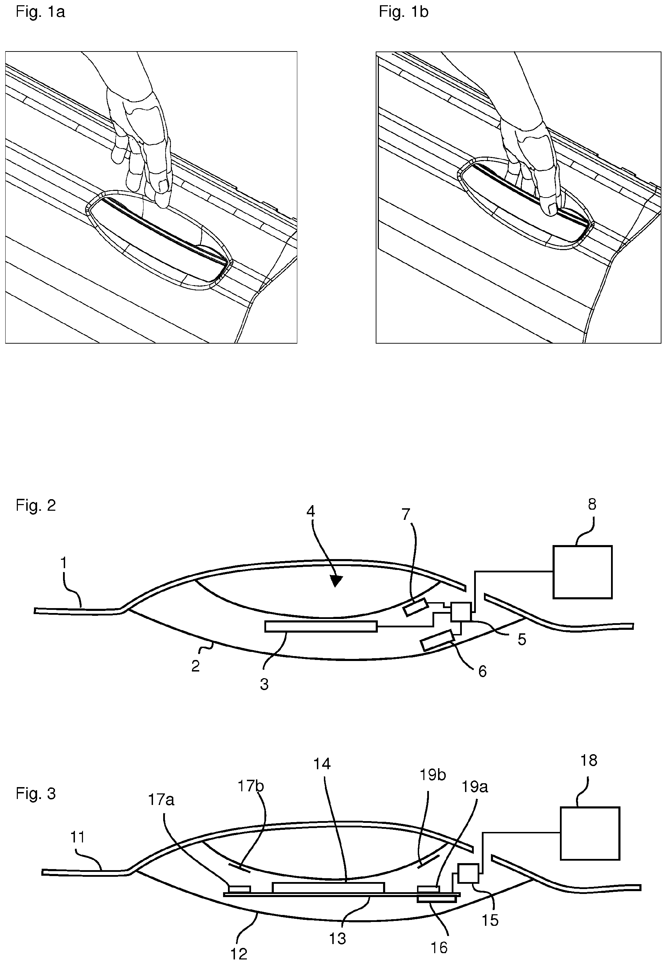

Die Figuren 1a und 1b verdeutlichen, was im Zusammenhang mit dieser Beschreibung unter Hintergreifen eines feststehenden Türgriffes zu verstehen ist. In Figur 1a nähert sich ein Benutzer einem feststehenden Türgriff einer Fahrzeugtür an. Der feststehende Türgriff ist, wie unten weiter beschrieben wird, unbeweglich an der Fahrzeugtür angebracht. Gemäß der Erfindung überwachen Sensorkomponenten im feststehenden Türgriff, insbesondere ein kapazitiver Annäherungssensor, ob sich die Hand des Benutzers tatsächlich hinter dem Türgriff befindet. Nur wenn sich die Hand, wie beispielhaft in der Figur 1b gezeigt, hinter dem Türgriff bewegt, zeigt der zugehörige kapazitive Sensor ein diesbezügliches Signal. Bislang werden entsprechende Annäherungen einer Hand hinter dem Türgriff beispielsweise bei kapazitiven Sensoren in Keyless-Entry-Systemen verwendet.

Bewegt der Benutzer seine Hand in die Stellung der Figur 1b, wird durch das Auslösen des kapazitiven Sensors eine Reihe weiterer Sensoren im Türgriff aktiviert, wie unten gezeigt.

Figur 2 zeigt ein erstes Ausführungsbeispiel eines erfindungsgemäßen Türgriffes in einer schematischen Darstellung. Gezeigt ist ein schematischer Schnitt durch den Türgriff, wie er in den Figuren 1a und 1b in dreidimensionaler Darstellung gezeigt ist. Der Türgriff ist fest an einem Türblech 1 angeordnet, wobei eine Handhabe 2 beispielsweise in den Endbereichen an dem Türblech festgelegt ist. An der Handhabe können dafür endseitig Befestigungsmittel vorgesehen sein, die das Türblech 1 auch durchgreifen können, die Details sind jedoch hier nicht gezeigt, da sie für die Erfindung nicht wesentlich sind. Im Inneren der Handhabe 2 ist ein kapazitiver Sensor 3 angeordnet. Dieser Sensor ist zur Innenseite der Handhabe, also zur Türseite gerichtet und überwacht das Hintergreifen einer Hand in den freien Raum 4 hinter dem Griff. Zur Außenseite hin kann der kapazitive Griff beispielsweise geschirmt ausgebildet sein, um gegenüber Annäherung von der Außenseite unempfindlich zu sein. Es ist beispielsweise möglich, die kapazitive Sensorik 3 mit einer Sensorelektrode und einer aktiven Schirmung auszustatten, wie sie im Stand der Technik bei sogenannten Active-Shield-Sensoren bekannt ist.

Der kapazitive Sensor 3 ist mit einer Steuereinrichtung 5 gekoppelt. Der kapazitive Sensor 3 wird gemäß diesem Ausführungsbeispiel jederzeit aktiv gehalten, so dass ein Hintergreifen des Türgriffes detektierbar ist. Erfolgt ein solches Hintergreifen, aktiviert die Steuerschaltung 5 die Sensoren 6 und 7. Der Sensor 6 ist ein weiterer kapazitiver Sensor, der mit seinem Erfassungsbereich einen kurzen Abschnitt der nach außen gerichteten Türgriffseite überwacht. Auf der Seite der Handhabe, die dem von Sensor 6 überwachten Bereich abgewandt ist, ist ein kraftempfindlicher Sensor 7 angeordnet. Dieser Sensor ist in diesem Ausführungsbeispiel als Piezo-Sensor ausgebildet und mit der Handhabefläche auf der Innenseite gekoppelt. Der Sensor 6 überwacht Annäherungen des Daumens einer Hand des Benutzers, während der Sensor 7 eine Druckausübung auf die Innenseite des Griffes überwacht. Der unmittelbar vor dem Sensor 7 liegende Bereich kann dafür aus einem verformbaren Material gebildet sein, z.B. einem Elastomer, wenn das Griffmaterial an sich nur extrem geringe Verformungen zulässt.

Die Steuerschaltung 5 ist mit dem elektronischen Schloss 8 gekoppelt, welches durch Ansteuerung zu einer Öffnung der Tür veranlasst werden kann. Das Schloss 8 ist hier symbolhaft dargestellt, es kann insbesondere eine elektrisch betätigbare Drehfalle aufweisen, welche die Tür in Zusammenwirkung mit einem Sperrbolzen sicher festhalten oder öffnen kann.

Die Steuereinrichtung 5 überwacht die Signale sowohl des kapazitiven Sensors 3 als auch des kapazitiven Sensors 6 und des Piezo-Sensors 7. Nur wenn alle drei Sensoren signalisieren, dass die Hand des Benutzers hinter dem Türgriff geführt wurde und ein Daumenabschnitt vor dem Sensor 6 liegt sowie Druck auf den Sensor 7 ausgeübt wird, wird eine bewusste Betätigung der Tür erkannt und das Schloss 8 entsperrt. Diese Kopplung der Sensoren führt zu einer besonders sicheren Erfassung einer bewussten und gezielten Betätigung. Der Kraftsensor 7 stellt außerdem sicher, dass der Türgriff fest umgriffen ist und eine Kraft in Öffnungsrichtung ausgeübt wird. Die elektrische Türöffnung kann dann den Benutzer nicht unangenehm überraschen, da seine Kraftausübung bereits in die Öffnungsrichtung wirkt und entsprechend die Tür nicht vor seine Hand, insbesondere den Handrücken schlagen kann.

Anhand dieses Schemas wird verständlich, dass zufällige Umgebungseinflüsse kaum eine Auslösung bewirken können. Nur wenn ein Gegenstand hinter dem Türgriff gelangt und von dort einen Druck auf den innenliegenden Sensor 7 ausübt und zeitgleich auch eine Annäherung von außen erfolgt, wird ein Öffnungswunsch erkannt.

Grundsätzlich ist es auch möglich, den Sensor 6 als Drucksensor auszubilden, so dass auf zueinander abgewandten Abschnitten des Türgriffes im Bereich der Sensoren 6 und 7 eine Quetschkraft ausgeübt werden muss, um eine Türöffnung zu erreichen.

Dann kann der Sensor 6 ebenfalls als Piezo-Sensor ausgebildet sein oder als anderer Kraftsensor.

Figur 3 zeigt ein anderes Ausführungsbeispiel mit einer Griff-Handhabe 12, die an einem Türblech 11 festgelegt ist. In diesem Beispiel sind sämtliche Sensorkomponenten auf einer Platine 13 angeordnet. Im mittleren Bereich der Platine 13 ist der kapazitive Sensor 14 ausgebildet, links von dem kapazitiven Sensor 14 ist ein induktiver Sensor 17a, 17b angeordnet. Eine Spulenanordnung 17a ist auf der Platine 13 aufgebracht und ein metallischer Sensorteil 17b ist beabstandet von der Spulenanordnung 17a auf der Innenseite der Handhabe platziert. Eine entsprechende Sensorgestaltung ist auch rechts von dem kapazitiven Sensor 14 in Gestalt des Sensors 19a, 19b ausgebildet. Auch dort ist ein metallischer Teil 19b an der Innenseite der Handhabe befestigt, während einer Spulenanordnung 19a auf der Platine 13 ausgebildet ist. Ein weiterer kapazitiver Sensor 16 überwacht wiederum denjenigen Teil, der dem Fahrzeug in diesem Abschnitt abgewandt ist.

Die Platine ist mit einer Steuereinrichtung 15 gekoppelt, wobei diese Steuereinrichtung 15 grundsätzlich auch auf der Platine selbst angeordnet sein kann. Ein Türschloss 18 ist von der Steuereinrichtung 15 ansteuerbar und zur Öffnung zu veranlassen. Sensoren mit induktiver Kopplung sind im Stand der Technik bekannt, insbesondere als sogenannte LDC-Sensoren. Dieses Ausführungsbeispiel weist insgesamt vier Sensoren zur Betätigungsüberwachung auf. Die Sensoren 17a, 17b und 19a, 19b detektieren eine Abstandsänderung oder Lageveränderung der metallischen Teile 17b, 19b gegenüber dem jeweiligen Sensor 17a bzw. 17b. Diese Sensoren reagieren jedoch allgemein auf Lageänderungen, so dass beispielsweise ein Torsion des Türgriffes oder eine Verformung bereits als Betätigung erkannt werden könnte. Es kann mit diesen Sensoren nicht entschieden werden, ob sich die Spulen den jeweiligen Gegenstücken annähern, oder ob der Griff von seiner Innenseite her verformt oder belastet wird. Hier kommt der kapazitive Annäherungssensor 14 ins Spiel, welcher die Überwachung eines Hintergreifens gemäß vorstehender Erläuterung übernimmt. Nur wenn sowohl ein Hintergreifen der Handhabe festgestellt wird als auch eine Betätigung durch Verformung des Türgriffes, und außerdem die Anlage im Bereich des Sensors 16 auf der Außenseite stattfindet, wird die Steuerschaltung 15 eine Betätigung des Türgriffes erkennen und das Türschloss öffnen.

Die gezeigten Ausführungsbeispiele erhöhen deutlich die Sicherheit bei der Erkennung eines eindeutigen Bedienwunsches. Die Sicherheit der Ansteuerung von elektrischen Türschlössern mittels feststehenden Türgriffen wird damit erhöht.

## Patentansprüche

1. Fahrzeugtürgriff mit einer Sensoranordnung zur Erfassung eines Bedienwunsches, wobei der Fahrzeugtürgriff (2; 12) zur Betätigung eines elektrischen Schlosses (8) ausgebildet ist,
wobei der Türgriff (2; 12) derart geformt ist, dass ein Benutzer den Türgriff (2; 12) zur Betätigung in einem freien Raum (4) zwischen Türgriff (2; 12) und Fahrzeugtür hintergreift, wobei die dem Fahrzeug (1; 11) zugewandte Seite des Türgriffs (2; 12) als Innenseite des Türgriffs (2; 12) bezeichnet wird und die vom Fahrzeug abgewandte Seite des Türgriffs (2; 12) als Außenseite bezeichnet wird,
wobei der Türgriff (2; 12) eine Ansteuerungs- und Auswerteelektronik (5; 15) enthält, welche in Abhängigkeit von Signalen der Sensoranordnung Steuersignale für das elektrische Türschloss (8) generiert,
wobei die Sensoranordnung wenigstens einen ersten kapazitiven Sensor (3; 14) aufweist, welcher in dem Türgriff (2; 12) angeordnet ist, wobei der kapazitive Sensor (3; 14) zu der Innenseite des Türgriffs (2; 12) ausgerichtet ist und einen bei Betätigung des Türgriffs (2; 12) zu hintergreifenden ersten Griffabschnitt überwacht,
wobei die Sensoranordnung wenigstens einen zweiten (6; 16) und einen dritten (7; 17a, 17b; 19a, 19b) Sensor aufweist, die entlang der axialen Grifferstreckung versetzt zu dem kapazitiven Sensor (3; 14) in dem Türgriff (2; 12) angeordnet sind,
wobei der zweite Sensor (6; 16) zu der Außenseite des Türgriffs (2; 12) ausgerichtet ist und eine Berührung des Türgriffs (2; 12) von der Außenseite in einem zweiten Griffabschnitt überwacht und
wobei der dritte Sensor (7; 17a, 17b; 19a, 19b) zu der Innenseite des Türgriffs (2; 12) ausgerichtet ist und eine Berührung von der Innenseite in dem zweiten Griffabschnitt überwacht,
wobei die Sensoranordnung mit der Ansteuerungs- und Auswerteelektronik (5; 15) gekoppelt ist, **dadurch gekennzeichnet,**
**dass** der Fahrzeugtürgriff als feststehender Türgriff (2, 12) ausgebildet ist, und
**dass** die Ansteuerungs- und Auswerteelektronik (5; 15) ein Öffnungssignal dann generiert, wenn sowohl der kapazitive Sensor (3; 14) ein Hintergreifen des Türgriffs (2; 12) erfasst und zeitgleich der zweite (6; 16) und der dritte Sensor (7; 17a, 17b; 19a, 19b) jeweils eine Berührung erfassen.

2. Fahrzeugtürgriff gemäß Anspruch 1, wobei die Ansteuerungs- und Auswerteelektronik (5; 15) zur Aktivierung und Deaktivierung des zweiten (6; 16) und dritten (7; 17a, 17b; 19a, 19b) Sensors ausgebildet ist, wobei die Ansteuerungs- und Auswerteelektronik (5; 15) den ersten kapazitiven Sensor (3; 14) überwacht und den zweiten (6; 16) und den dritten Sensor (7; 17a, 17b; 19a, 19b) in Abhängigkeit von den Signalen des ersten kapazitiven Sensors (3; 14) aktiviert.

3. Fahrzeugtürgriff gemäß Anspruch 1 oder 2, wobei der dritte Sensor (7; 17a, 17b; 19a, 19b) als Kraftsensor ausgebildet ist, insbesondere als Piezo-Sensor oder als LDC-Sensor.

4. Fahrzeugtürgriff nach Anspruch 3, wobei der Türgriff (2; 12) im Bereich des dritten Sensors (7; 17a, 17b; 19a, 19b) wenigstens abschnittsweise derart mechanisch verformbar ausgebildet ist, dass eine Kraftübertragung auf den im (2; 12) angeordneten Sensor verbessert ist, wobei vorzugsweise der Griff (2; 12) in dem den dritten Sensor (7; 17a, 17b; 19a, 19b) bedeckenden Abschnitt wenigstens teilweise mit einer Abdeckung aus einem Elastomer versehen ist.

5. Fahrzeugtürgriff nach einem der vorangehenden Ansprüche, wobei der zweite Sensor (6; 16) als kapazitiver Sensor ausgebildet ist.

6. Fahrzeugtürgriff nach einem der Ansprüche 1 bis 4, wobei der zweite Sensor (6; 16) als Kraftsensor ausgebildet ist.

7. Fahrzeugtürgriff nach einem der vorangehenden Ansprüche, wobei entlang der Grifferstreckung weitere Kraftsensoren angeordnet sind, welche eine Kraftausübung von der Innenseite des Griffs (2; 12) erfassen.

8. Verfahren zum Erfassen eines Bedienwunsches an einem Fahrzeugtürgriff, wobei der Fahrzeugtürgriff als feststehender Türgriff (2; 12) zur Betätigung eines elektrischen Schlosses (8) ausgebildet ist,
wobei der Türgriff (2; 12) derart geformt ist, dass ein Benutzer den Türgriff (2; 12) zur Betätigung in einem freien Raum (4) zwischen Türgriff (2; 12) und Fahrzeugtür hintergreift, wobei die dem Fahrzeug (1; 11) zugewandte Seite des Türgriffs (2; 12) als Innenseite des Türgriffs (2; 12) bezeichnet wird und die vom Fahrzeug abgewandte Seite des Türgriffs (2; 12) als Außenseite bezeichnet wird,
wobei der Türgriff (2; 12) eine Ansteuerungs- und Auswerteelektronik (5; 15) enthält, welche in Abhängigkeit von Signalen der Sensoranordnung Steuersignale für das elektrische Türschloss (8) generiert,
wobei eine Sensoranordnung zur Erfassung eines Bedienwunsches vorgesehen ist,
mit den Schritten
Erfassen eines Hintergreifens des Türgriffs (2; 12) in einem ersten Abschnitt durch Überwachen der Signale eines ersten kapazitiven Sensors (3; 14) der Sensoranordnung,
Erfassen einer Berührung des Türgriffs von der Außenseite in einem zweiten Abschnitt durch Überwachen der Signale eines zweiten Sensors (6; 16) der Sensoranordnung,
Erfassen einer Berührung des Türgriffs (2; 12) von der Innenseite in dem zweiten Abschnitt durch Überwachen der Signale eines dritten Sensors (7; 17a, 17b; 19a, 19b) der Sensoranordnung,
Erzeugen von Steuersignalen mit der Ansteuerungs- und Auswerteelektronik (5; 15), wobei ein Öffnungssignal dann generiert wird, wenn zeitgleich sowohl ein Hintergreifen des Türgriffs (2; 12) erfasst wird und der zweite (6; 16) und der dritte (7; 17a, 17b; 19a, 19b) Sensor jeweils eine Berührung erfassen.

9. Verfahren nach Anspruch 8, wobei eine Aktivierung und Überwachung des zweiten Sensors (6; 16) und des dritten Sensors (7; 17a, 17b; 19a, 19b) nur dann erfolgt, wenn ein Hintergreifen des Türgriffs (2; 12) erfasst wird.

10. Verfahren nach Anspruch 8 oder 9, wobei mit dem dritten Sensor (7; 17a, 17b; 19a, 19b) eine Kraftausübung auf die Innenseite des Türgriffs (2; 12) erfasst wird.

## Claims

1. Vehicle door handle having a sensor assembly for detecting an operation request, wherein the vehicle door handle is formed (2; 12) for actuating an electric lock (8),
wherein the door handle (2; 12) is shaped in such a manner that a user in order to actuate it reaches behind the door handle into an open space (4) between the door handle (2; 12) and the vehicle door, wherein the side of the door handle (2; 12) that is directed towards the vehicle (1; 11) is referred to as the inner side of the door handle (2; 12) and the side of the door handle that is facing away from the vehicle is referred to as the outer side,
wherein the door handle (2; 12) comprises a electronic control and evaluation device (5; 15), which generates control signals for the electric door lock (8) in dependence of signals from the sensor assembly,
wherein the sensor assembly has at least one first capacitive sensor (3; 14) that is arranged in the door handle (2; 12), whereby the capacitive sensor (3; 14) is oriented towards the inner side of the door handle, and monitors a first handle section which is to be reached behind and grasped when actuating the handle,
wherein the sensor assembly comprises at least a second (6;16) and a third (7; 17a, 17b; 19a, 19b) sensor which are arranged along the axial extension of the handle in an offset manner in relation to the capacitive sensor (3; 14) in the door handle (2; 12),
wherein the second sensor (6; 16) is oriented towards the outer side of the door handle, and monitors a touching of the door handle from the outer side in a second handle section, and
wherein the third sensor (7; 17a, 17b; 19a, 19b) is oriented towards the inner side of the door handle (2; 12), and monitors a touching from the inner side in the second handle section,
**characterized in that**
the door handle is formed as a fixed door handle (2; 12), wherein the electronic control and evaluation device (5; 15) generates an opening signal, when the capacitive sensor (3; 14) detects a reaching behind the door handle, and at the same time the second (6; 16) and the third sensor (7; 17, 17b; 19a, 19b) simultaneously each detect a touching.

2. Vehicle door handle according to claim 1, wherein the electronic control and evaluation device (5; 15) is designed for the activation and deactivation of the second (6; 16) and third (7; 17a, 17b; 19a, 19b) sensor, whereby the electronic control and evaluation device (5; 15) monitors the first (3;14) capacitive sensor and activates the second (6; 16) and third (7; 17a, 17b; 19a, 19b) sensor in dependence of the signals from the first capacitive sensor.

3. Vehicle door handle according to claim 1 or 2, wherein the third (7; 17a, 17b; 19a, 19b) sensor is designed as a force sensor, in particular as a piezo sensor or as a LDC-sensor.

4. Vehicle door handle according to claim 3, wherein the door handle (2; 12) in the is designed in a mechanically deformable manner, at least in sections, within the area of the third (7; 17a, 17b; 19a, 19b) sensor, so that a force transmission towards the sensor that is arranged within the door handle (2; 12) is improved, whereby the handle (2; 12) is preferably arranged at least partially with a cover made from an elastomer in the section that is covering the third (7; 17a, 17b; 19a, 19b) sensor.

5. Vehicle door handle according to one of the preceding claims, wherein the second (6; 16) sensor is a capacitive sensor.

6. Vehicle door handle according to one of the claims 1 to 4, wherein the second sensor is a force sensor.

7. Vehicle door handle according to one of the preceding claims, wherein additional force sensors are arranged along the handle extension, which detect the exerting of force from the inner side of the handle (2; 12).

8. Method for detecting an operation request on a vehicle door handle (2; 12), wherein the vehicle door handle (2; 12) is designed as a fixed door handle (2; 12) for actuating an electric lock,
whereby the door handle (2; 12) is shaped in such a manner that a user in order to actuate it reaches behind the door handle (2; 12) into an open space (4) between the door handle (2; 12) and the vehicle door, wherein the side of the door handle (2; 12) that is directed towards the vehicle (1; 11) is referred to as the inner side of the door handle (2; 12) and the side of the door handle (2; 12) that is facing away from the vehicle (1; 11) is referred to as the outer side,
wherein the door handle (2; 12) comprises a electronic control and evaluation device (5; 15), which generates control signals for the electric door lock (8) in dependence of signals from the sensor assembly,
wherein a sensor assembly is designed for the detecting of an operation request,
comprising the steps of
detecting of a reaching behind and grasping of the door handle (2; 12) within a first section by means of a monitoring of the signals of a first capacitive sensor (3; 14) of the sensor assembly,
detecting of a touching of the door handle (2; 12) from the outside within a second section by means of a monitoring of the signals of a second sensor (6; 16) of the sensor assembly,
detecting of a touching of the door handle (2; 12) from the inner side within the second section by means of a monitoring of the signals of a third sensor (7; 17a, 17b; 19a, 19b) of the sensor assembly,
generating control signals with the electronic control and evaluation device (5; 15), wherein an opening signal is generated when a reaching behind and grasping of the door handle (2; 12) is detected and at the same time the second (6; 16) and the third (7; 17a, 17b; 19a, 19b) sensor each detect a respective touching.

9. Method according to claim 8, wherein an activation and monitoring of the second sensor (6; 16) and of the third sensor (7; 17a, 17b; 19a, 19b) is only carried out when a reaching behind and grasping of the door handle (2; 12) is detected.

10. Method according to claim 8 or 9, wherein a force exertion on the inner side of the door handle (2; 12) is detected by means of the third sensor (7; 17a, 17b; 19a, 19b).

## Revendications

1. Poignée de porte de véhicule, comportant un dispositif de détection pour la détection d'un souhait de manœuvre, la poignée de porte de véhicule (2 ; 12) étant conçue pour actionner une serrure électrique (8),
la poignée de porte (2 ; 12) étant conformée de manière à ce qu'un utilisateur saisisse la poignée de porte (2 ; 12) par l'arrière pour actionnement dans un espace libre (4) entre la poignée de porte (2 ; 12) et la porte de véhicule, la face tournée vers le véhicule (1 ; 11) de la poignée de porte (2 ; 12) étant désignée comme face interne de la poignée de porte (2 ; 12) et la face détournée du véhicule de la poignée de porte (2 ; 12) étant désignée comme face externe,
la poignée de porte (2 ; 12) contenant un système électronique de commande et d'exploitation (5 ; 15) qui, en fonction de signaux du dispositif de détection, génère des signaux de commande pour la serrure de porte électrique (8),
le dispositif de détection présentant au moins un premier capteur capacitif (3 ; 14) qui est disposé dans la poignée de porte (2 ; 12), le capteur capacitif (3 ; 14) étant orienté vers la face interne de la poignée de porte (2 ; 12) et surveillant une première section de poignée à saisir par l'arrière pour l'actionnement de la poignée de porte (2 ; 12),
le dispositif de détection présentant au moins un deuxième (6 ; 16) et un troisième (7 ; 17a, 17b ; 19a, 19b) capteurs qui sont disposés le long de l'extension axiale de la poignée, décalés par rapport au capteur capacitif (3 ; 14), dans la poignée de porte (2 ; 12),
le deuxième capteur (6 ; 16) étant orienté vers la face externe de la poignée de porte (2 ; 12) et surveillant un contact avec la poignée de porte (2 ; 12) depuis la face externe dans une seconde section de poignée, et
le troisième capteur (7 ; 17a, 17b ; 19a, 19b) étant orienté vers le la face interne de la poignée de porte (2 ; 12) et surveillant un contact depuis la face interne dans une seconde section de poignée,
le dispositif de détection étant couplé au système électronique de commande et d'exploitation (5 ; 15),
**caractérisée en ce que**
la poignée de porte de véhicule est réalisée sous forme d'une poignée de porte fixe (2, 12), et
que le système électronique de commande et d'exploitation (5 ; 15) génère un signal d'ouverture quand à la fois le capteur capacitif (3 ; 14) détecte une saisie par l'arrière de la poignée de porte (2 ; 12) et simultanément le deuxième (6 ; 16) et le troisième capteurs (7 ; 17a, 17b ; 19a, 19b) détectent respectivement un contact.

2. Poignée de porte de véhicule selon la revendication 1, dans laquelle le système électronique de commande et d'exploitation (5 ; 15) est conçu pour activer et désactiver le deuxième (6 ; 16) et le troisième capteurs (7 ; 17a, 17b ; 19a, 19b),
le système électronique de commande et d'exploitation (5 ; 15) surveillant le premier capteur capacitif (3 ; 14) et le deuxième (6 ; 16) et le troisième capteur (7 ; 17a, 17b ; 19a, 19b) en fonction des signaux du premier capteur capacitif (3 ; 14)

3. Poignée de porte de véhicule selon la revendication 1 ou 2, dans laquelle le troisième capteur (7 ; 17a, 17b ; 19a, 19b) est réalisé sous forme d'un capteur de force, en particulier sous forme d'un piézo-capteur ou d'un capteur LDC.

4. Poignée de porte de véhicule selon la revendication 3, dans laquelle la poignée de porte (2 ; 12), au niveau du troisième capteur (7 ; 17a, 17b ; 19a, 19b), est réalisée du moins par endroits de manière à être déformable mécaniquement de façon à améliorer une transmission de force vers le capteur disposé dans la poignée de porte (2 ; 12), la poignée (2 ; 12) étant de préférence, dans la section recouvrant le troisième capteur (7 ; 17a, 17b ; 19a, 19b), du moins partiellement pourvue d'un recouvrement en élastomère.

5. Poignée de porte de véhicule selon une des revendications précédentes, dans laquelle le deuxième capteur (6 ; 16) est réalisé sous forme d'un capteur capacitif.

6. Poignée de porte de véhicule selon une des revendications 1 à 4, dans laquelle le deuxième capteur (6 ; 16) est réalisé sous forme d'un capteur de force.

7. Poignée de porte de véhicule selon une des revendications précédentes, dans laquelle, le long de l'extension de la poignée, sont disposés d'autres capteurs de force qui détectent un exercice de force par la face interne de la poignée (2 ; 12).

8. Procédé de détection d'un souhait de manœuvre au niveau d'une poignée de porte de véhicule, la poignée de porte de véhicule étant conçue sous forme d'une poignée de porte fixe (2 ; 12) pour l'actionnement d'une serrure électrique (8),
la poignée de porte (2 ; 12) étant conformée de manière à ce qu'un utilisateur saisisse la poignée de porte (2 ; 12) par l'arrière pour actionnement dans un espace libre (4) entre la poignée de porte (2 ; 12) et la porte de véhicule, la face tournée vers le véhicule (1 ; 11) de la poignée de porte (2 ; 12) étant désignée comme face interne de la poignée de porte (2 ; 12) et la face détournée du véhicule de la poignée de porte (2 ; 12) étant désignée comme face externe,
la poignée de porte (2 ; 12) contenant un système électronique de commande et d'exploitation (5 ; 15) qui, en fonction de signaux du dispositif de détection, génère des signaux de commande pour la serrure de porte électrique (8),
étant prévu un dispositif de détection pour la détection d'un souhait de manœuvre,
comportant les étapes suivantes :
détection d'une saisie par l'arrière de la poignée de porte (2 ; 12) dans une première section par surveillance des signaux d'un premier capteur capacitif (3 ; 14) du dispositif de détection,
détection d'un contact avec la poignée de porte par la face externe dans une seconde section par surveillance des signaux d'un deuxième capteur (6 ; 16) du dispositif de détection,
détection d'un contact avec la poignée de porte (2 ; 12) par la face interne par surveillance des signaux d'un troisième capteur (7 ; 17a, 17b ; 19a, 19b) du dispositif de détection,
génération de signaux de commande à l'aide du système électronique de commande et d'exploitation (5 ; 15),
un signal d'ouverture étant alors généré si à la fois simultanément une saisie par l'arrière de la poignée de porte (2 ; 12) est détectée et si le deuxième (6 ; 16) et le troisième capteurs (7 ; 17a, 17b ; 19a, 19b) détectent respectivement un contact.

9. Procédé selon la revendication 8, dans lequel une activation et une surveillance du deuxième capteur (6 ; 16) et du troisième capteur (7 ; 17a, 17b ; 19a, 19b) n'ont lieu que si une saisie par l'arrière de la poignée de porte (2 ; 12) est détectée.

10. Procédé selon la revendication 8 ou 9, dans lequel à l'aide du troisième capteur (7 ; 17a, 17b ; 19a, 19b) un exercice de force sur la face interne de la poignée de porte (2 ; 12) est détecté.
